# EUROPEAN PATENT APPLICATION

(11) **EP 3 206 232 A1**
(43) Date of publication of application: **16.08.2017**
(21) Application number: 16305161.8
(22) Date of filing: 12.02.2016
(51) Int. Cl.: H01L 29/423, H01L 29/66, H01L 29/778, H01L 29/16

(54) **METHOD FOR OBTAINING A GRAPHENE-BASED FET, IN PARTICULAR A MEMORY FET, EQUIPPED WITH AN EMBEDDED DIELECTRIC ELEMENT MADE BY FLUORINATION**

(71) Applicant: Centre National de la Recherche Scientifique CNRS, 75794 Paris Cedex 16 (FR); Supelec, 91192 Gif sur Yvette (FR); Université Pierre et Marie Curie, 75252 Paris Cedex 05 (FR)
(72) Inventor: BOUTCHICH, Mohamed, 92400 COURBEVOIE (FR); OUERGHI, Abdelkarim, 91120 PALAISEAU (FR); LAI, Chao-Sung, 330 Taoyuan City (TW); HO, Kuan-I, 238 New Taipei City (TW)
(74) Representative: Vidon Brevets & Stratégie

(57) **Abstract**

The invention relates to a method for obtaining a field effect transistor, comprising steps of:
- forming (100) a multi-layer graphene stack on a face of a base substrate;
- depositing (200) a source and a drain electrode on the multi-layer graphene stack;
- forming a conductive multi-layer graphene block by lithography and etching process;
- fluorinating (600) the graphene block, using the source and drain electrodes as a fluorination-protective mask, during a predetermined period and at a predetermined temperature, such that an upper part of said graphene block is converted into fluorographene over a given thickness portion, to form a dielectric element within the graphene block;
- depositing (700) a gate electrode on the dielectric element.

## Description

### 1. FIELD OF THE INVENTION

The field of the invention is that of field effect transistors, commonly referred to as FET transistors.

More specifically, the invention pertains to a method of fabrication of a graphene-based field effect transistor component.

The invention can be applied especially but not exclusively to applications such as for example: non-volatile memories, sensing devices (e.g. photodetector, chemical detector), energy harvesting devices.

### 2. TECHNOLOGICAL BACKGROUND

In the last few decades, the semiconductor industry has been able to maintain steady improvements of performance of silicon-based devices by the scaling of dimensions thereof. However, as silicon-based devices suffer from technological and physics limitations, there have been important efforts to seek alternative device technologies to attempt to pursue the Moore's law for the mass production of electronic applications. One such alternative is the use of graphene in semiconductor structures.

Graphene is a layer of carbon atoms bonded in a honeycomb crystal lattice. In particular, graphene has high carrier mobility and good mechanical flexibility allowing it to be used to build field effect transistors (FETs) on oxidized silicon wafer, the graphene acting as conductive channel.

Graphene-based FETs using silicon dioxide (SiO₂), aluminium oxide (Al₂O₃) or graphene oxide (GO) dielectric layers as gate insulator material have been recently developed as realistic devices compatible with standard CMOS and Integrated Circuit architecture. Usually, gate dielectric is comprised between the graphene-based conductive channel and the gate electrode. Gate dielectric ensures the control of flow of carriers travelled through the channel via the gate electrode.

But these FETs are facing a certain number of obstacles to their technological development in terms of electronic performance and fabrication process. Typically, the gate dielectric is formed by successive deposits of thin layers of dielectric material on the conductive channel, before deposit of the metallic gate. The method of fabrication of such FETs is therefore relatively complex to implement and requires a substantial number of successive deposits of thin layers, which is costly in terms of fabrication.

Another drawback of this kind of method is that a carrier trapping phenomena can occur at the interface graphene/dielectric due to the fabrication process.

Another drawback is that the FETs obtained by this kind of method have a size of band gap relatively narrow.

More recently, developers discovered fluorinated graphene could be a dielectric material suitable for use in the fabrication of FET devices. The process to manufacture such FET devices notably comprises coating, by CVD process, a thin layer of graphene on a first suitable substrate, then transferring this thin layer of graphene on a second substrate of SiO₂/Si, and reiterating these two steps (grow and transfer) as many times as necessary to obtain the desired multi-layer graphene stack.

However transferring graphene layers is a delicate process which is difficult to implement and costly. For the time being, this known method does not present any real prospects of industrial-scale exploitation.

Another drawback is that transferring steps generates the incidence of defects in the graphene layers during fabrication, thereby reducing performances of the FET devices (for instance these defects are responsible for current leakage in the gate dielectric).

### 3. GOALS OF THE INVENTION

The invention, in at least one embodiment, is aimed especially at overcoming at least some of cited these different drawbacks of the prior art.

More specifically, it is a goal of at least one embodiment of the invention to provide a technique for fabrication a graphene-based field effect transistor that is simple and costs little to implement.

It is also an aim of at least one embodiment of the invention to provide a technique of this kind suitable for industry.

It is also an aim of at least one embodiment of the invention to provide a technique of this kind enabling to obtain a graphene-based field effect transistor having good electronic properties.

### 4. SUMMARY OF THE INVENTION

A particular embodiment of the invention proposes a method for obtaining a field effect transistor, comprising steps of:
a) forming a multi-layer graphene stack on a face of a base substrate, said multi-layer graphene stack having a predefined thickness;
b) depositing (200) a source and a drain electrode;
c) obtaining, by fluorinating, a graphene block partially fluorinated from said multi-layer graphene stack, the graphene block partially fluorinated comprising a fluorographene part forming a dielectric element within the graphene block;
d) depositing a gate electrode.

Thus, the field effect transistor obtained comprises a dielectric element directly embedded in the graphene block, which graphene block acts as conductive channel. Contrary to the prior method, this avoids the implementation of transfer steps of layers of graphene therefore offering a method that is simpler and less costly. In addition, the multi-layer graphene stack thus obtained is of higher quality (defects between layers reduced and layer interfaces better defined). This ensures an effective conversion from graphene into fluorographene during the fluorinating step so that the transistor thus formed has therefore improved electric properties.

Depositing a source, drain and gate electrodes is carried out by a lithography treatment flowed by an etching treatment.

According to a first embodiment of the invention, the source and drain electrodes are deposited on an upper face of said multi-layer graphene stack, said step c) comprising steps of:
α) forming, by lithography, an etch-protective layer over an target area of a upper face of said multi-layer graphene stack, which extends between the source and drain electrodes,
β) etching, using the etch-protective layer and the source and drain electrodes as an etch-protective mask, said multi-layer graphene stack over the predefined thickness to form a conductive multi-layer graphene block;
γ) removing said etch-protective layer from said graphene block to reveal said target area;
δ) fluorinating said graphene block, using the source and drain electrodes as a fluorination-protective mask, during a predetermined period and at a predetermined temperature, such that an upper part of said graphene block corresponding to said revealed target area is converted into fluorographene over a given thickness portion, to form a dielectric element within said graphene block;
and said step d) is performed on an upper face of said dielectric element.

The graphene-based field effect transistor thus obtained in this first embodiment is an elementary field effect transistor adapted to perform an elementary logic function of switch type. It comprises a dielectric element, which acts as gate dielectric, directly embedded in the graphene block, which acts as conductive channel. The gate dielectric, which is comprised between the conductive channel and the gate electrode, ensures the control of flow of carriers travelled through the channel via the gate electrode.

Another technical advantage of the method according to the invention is that the fluorinating step further converts the lateral walls of the graphene block into fluorographene, enabling the conductive channel to be insulated from its surroundings (because of the dielectric proprieties of the fluorographene). This reduces the risk of shortcut of the conductive channel and reduces the scattering of electrons at the channel edges therefore improving carrier mobility.

In other words, the part of said graphene block unexposed to the fluorination (i.e. masked by the fluorination-protective mask) forms the conductive channel (this part being made of graphene which is a conductive material), and the parts of said graphene block exposed to the fluorination (i.e. unmasked by the fluorination-protective mask) form: on the one hand, the gate dielectric for the part of block corresponding to the revealed target area, and the other hand, protective walls of the channel for the parts of said graphene block corresponding to the lateral walls (this parts being made of fluorographene which is a insulating material). Indeed, lateral walls of the graphene block being also unprotected by the mask, the result is a diffusion of fluorine over a given thickness portion also at lateral walls.

According to a particular feature, said step α) is carried out by electronic lithography comprising a step of depositing a electro-sensitive resin on the upper surface of said multi-layer graphene stack and a step of irradiating the electro-sensitive resin based on a pattern adapted to form said etch-protective layer over the target area.

According to an alternative feature, said step α) is carried out by photo-lithography comprising a step of depositing a photo-sensitive resin on the upper surface of said multi-layer graphene stack and a step of irradiating the photo-sensitive resin based on a pattern adapted to form said etch-protective layer over the target area.

According to a particular feature, the source and drain electrode having each a predefined width and being spaced from each other of a predefined distance, and said target area extends between the source and drain electrodes over the predefined width and the predefined distance.

Thus, the gate dielectric obtained after the fluorination step extends below the target area, over the predefined width and the predefined distance.

According to a particular feature, said step β) is carried out using a reactive ion etching (RIE).

This is a simple and efficient etching process to implement.

According to a particular feature, said step δ) consists in subjecting said graphene block to a Fluor-based plasmagenic gas.

A Fluor-based plasmagenic gas, such as CF₄, C₂F₆ CHF₃, CH₂F₂, CH₃F, SF₆, C₃F₈ or C₄F₈, is particularly well-adapted to form the gate dielectric within the graphene block.

According to a particular feature, in said step δ), the predetermined duration is comprised between 40 and 60 minutes and the predetermined temperature is comprised between 150 and 300 °C.

According to a particular feature, said multi-layer graphene stack having graphene terraces oriented according to a predefined orientation, said steps b) and c) are carried out as a function of said predefined orientation.

Steps b) and c) can be carried out either parallel or perpendicular to the predefined orientation of graphene layers in order optimize electronic properties of the field effect transistor.

According to a second embodiment of the invention, the source and drain electrodes are deposited on an upper face of said multi-layer graphene stack, said step c) comprising steps of:
α) forming, by lithography, an etch-protective layer over an target area of a upper face of said multi-layer graphene stack, which extends between the source and drain electrodes,
β) etching, using the etch-protective layer and the source and drain electrodes as an etch-protective mask, said multi-layer graphene stack over the predefined thickness to form a conductive multi-layer graphene block having the dielectric element ;
γ) removing said etch-protective layer from said graphene block to reveal said target area;
δ) fluorinating said graphene block, using the source and drain electrodes as a fluorination-protective mask, during a predetermined period and at a predetermined temperature, such that an upper part of said graphene block corresponding to said revealed target area is converted into fluorographene over a given thickness portion, to form a dielectric element within said graphene block;
ε) forming an electron trap dielectric element by ion implantation of said dielectric element;
ζ) depositing a thin layer of dielectric material on an upper face of said electron trap dielectric element;
and said step d) is performed on an upper face of said thin layer of dielectric material.

The graphene-based field effect transistor thus obtained in this second embodiment is a memory-type field effect transistor adapted to perform a non-volatile memory function. The ionized part of dielectric element (the upper part of fluorographene) acts as electron trap and the non-ionized part of dielectric element (the lower part of fluorographene) acts as tunnelling barrier, both directly embedded in the graphene block. The part of the graphene block which has not been fluorinated (i.e. made of graphene) acts as conductive channel. The dielectric thin layer, which acts as blocking oxide is comprised between the electron trap and the gate electrode, and ensures via the voltage applied to the gate electrode the control of flow of carriers travelling from the conductive channel to the electron trap through the tunnel barrier.

According to a particular feature, the base substrate is a silicon carbide substrate having a C-terminated face and a Si-terminated face, and said step of forming a graphene layer stack is carried by thermal treatment of the silicon carbide substrate from the C-terminated face or Si-terminated face.

As a function of the face of substrate from which the graphene layers are formed, certain electronic properties of the field effect transistor can be optimized. Indeed C-terminated face and Si-terminated face have different properties in terms of stacking configuration during the growth of graphene layers.

According to a third embodiment of the invention, the method comprises, before performing said step a), a step of depositing a boron nitride thin layer on a silicon carbide substrate to form the base substrate, said step c) comprising steps of:
α) fluorinating said multi-layer graphene stack, during a predetermined period and at a predetermined temperature, such that an upper part of said multi-layer graphene stack is converted into fluorographene over a given thickness portion;
β) forming, by lithography, an etch-protective layer over an target area of a upper face of said fluorinated multi-layer graphene stack;
γ) etching, using the etch-protective layer, said fluorinated multi-layer graphene stack over the predefined thickness to form the graphene block comprising the dielectric element;
δ) removing said etch-protective layer from said graphene block to reveal said dielectric element;
said step b) is performed after said step δ) such that the source and drain electrodes are deposited on an upper face of said silicon carbide (SiC) substrate, on either side of and at equal distance of the graphene block,
said step d) is performed on an upper face of said dielectric element.

The graphene-based field effect transistor thus obtained in this third embodiment is a memory-type field effect transistor adapted to perform a non-volatile memory function. It comprises a dielectric element, which acts as blocking oxide, directly embedded in the graphene block. The part of the graphene block which has not been fluorinated (i.e. made of graphene) acts as conductive channel (it is also commonly called "graphene floating gate" to store electrons). The boron nitride thin layer acts as tunnelling barrier. The dielectric element ensures via the voltage applied to the gate electrode the control of flow of carriers travelling to the floating gate through the tunnel barrier.

According to a particular feature, said graphene layer stack comprises a number of layers comprised between 2 and 16.

A number of graphene layers particularly comprised between 8 and 10 layers has showed positive results in terms of electrical performances of the transistor.

According to a particular feature, said step a) further comprises a step of doping of at least one layer of graphene of said multi-layer graphene stack.

### 5. LIST OF FIGURES

Other features and advantages of embodiments of the invention shall appear from the following description, given by way of an indicative and non-exhaustive examples and from the appended drawings, of which:
- **Figure 1** provides a flowchart of a particular embodiment of the method according to the invention;
- **Figures 2, 3, 4****,** **5, 6A, 6B****,** **7A, 7B****,** **8A, 8B****,** **9, 10A, 10B** are schematic drawings illustrating the principle of operation of the method according to the particular embodiment described in figure 1;
- **Figure 11** shows the structure, according to a perspective view, of a graphene-based field effect transistor obtained by implementation of the method of figure 1;
- **Figures 12, 13, 14** are cross-sectional views of the field effect transistor illustrated in figures 10A-10B, highlighting the structure of the conductive channel and gate dielectric;
- **Figure 15** graphically depicts the current-voltage characteristic obtained experimentally with a field effect transistor obtained by the method of the invention according to the first embodiment;
- **Figures 16A-16B** show the simplified structure of a graphene-based field effect transistor obtained by the method of the invention according to a second embodiment, respectively through a sectional and perspective view;
- **Figure 17A-17B** show the simplified structure of a graphene-based field effect transistor obtained by the method of the invention according to a third embodiment, respectively through a sectional and perspective view;
- **Figures 18 to 22** are schematic drawings illustrating the principle of operation of the method according to the third embodiment of the invention.

### 6. DETAILED DESCRIPTION

In all of the figures of the present document, identical elements and steps are designated by the same numerical reference sign.

The term "thin layer" here in the present document refers to a layer of material, the thickness of which is generally comprised between 0,10 nm (atomic layer) and 10 µm, as opposed to "thick layers", the thickness of which is generally above 10 µm.

### • First embodiment of the invention: Method for obtaining a graphene-based elementary field effect transistor

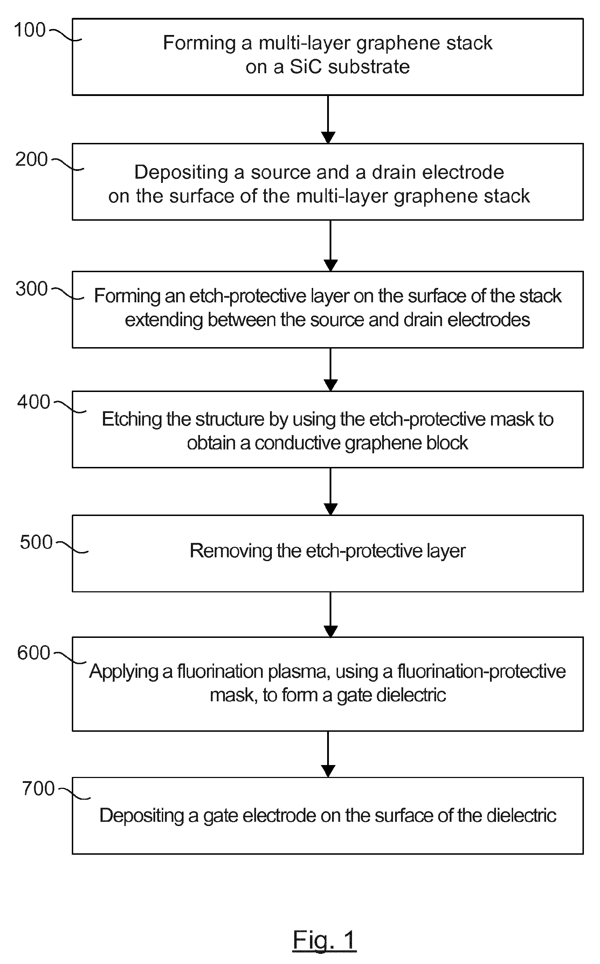

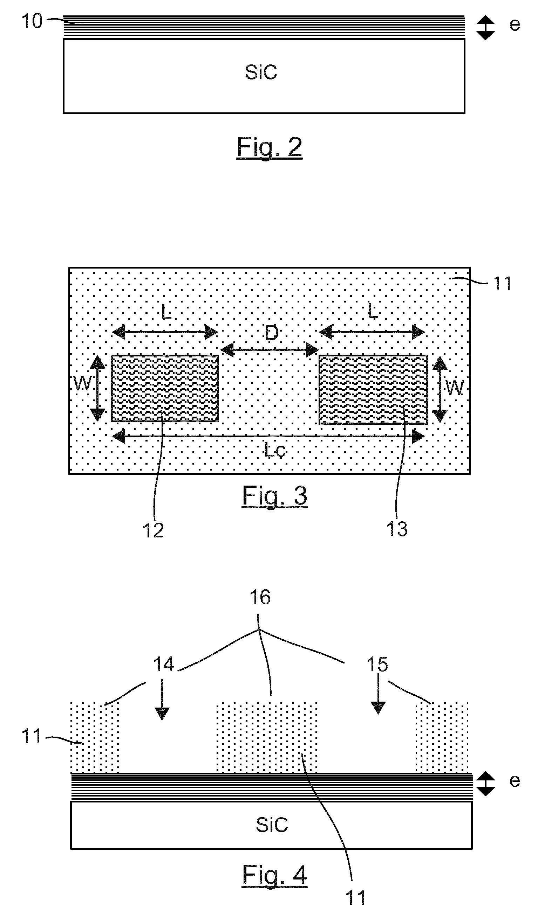

**Figure 1** is a flowchart of a particular embodiment of the method according to the invention. This particular embodiment is described in relation with **Figures 2, 3, 4****,** **5, 6A, 6B****,** **7A, 7B****,** **8A, 8B****,** **9, 10A, 10B** which schematically illustrates the principle of operation of the mains steps of the method.

The invention relates to a method of obtaining a field effect transistor made of graphene-based layers. The principle of the invention is to form, by growth of graphene layers and fluorination of a target part of graphene layers, a gate dielectric directly embedded in the graphene layers.

In step 100, a multi-layer graphene stack is formed on the surface of a SiC substrate using a high temperature thermal treatment. To that end, a SiC single crystal is heating at growth temperature (typically around 1500 to 1600 °C) for a predetermined duration (typically around 10 minutes for 1 to 15 layers) in a high vacuum (typically with a pressure of around 5.10⁻⁵ Torr) to produce superposed graphene layers by sublimation of Si atoms from SiC. Sublimation of Si atoms creates excess carbon in the form of graphene monolayers. This growth mechanism is also commonly known as "epitaxial graphene growth". A stack according to the invention is a set of superposed graphene layers.

A stack having a number of graphene layers comprised between 8 and 10 layers has showed positive results, but can be comprised between 2 and 16 layers. The number of layers can be controlled as a function of the growth parameters (pressure, growth temperature and growth duration).

**Figure 2** shows a cross-sectional view of a multi-layer graphene stack 10 on SiC as obtained at the end of step 100. The multi-layer graphene stack 10 has a predefined thickness e which depends on the number of layers (for example approximately around 4 nm for ten graphene layers, assuming that a graphene layer has a thickness typically around 0.34 - 0.35 nm). The multi-layer graphene stack 10 is electrically conductive (because of the intrinsic properties of graphene). A greater number of graphene layers can be of course envisaged but the manufacturing process should be lengthier and certain electrical properties of the component thus manufactured may decline.

The SiC substrate used for graphene growth has a Si-terminated face and a C-terminated face and growth of graphene can be carried out from one of these two faces. Each face of SiC substrate presents different physic properties having an impact on the stacking configuration of graphene layers formed on the SiC substrate, and therefore on the electronic properties of the field effect transistor (growth on the Si-terminated face allows to obtain a Bernal stacking whereas growth on the C-terminated face allows obtain a turbostatic stacking).

In the present example, the multi-layer graphene stack 10 is formed on the Si-terminated face, from which homogeneous graphene can be formed with a controlled number of layers having high carrier mobility.

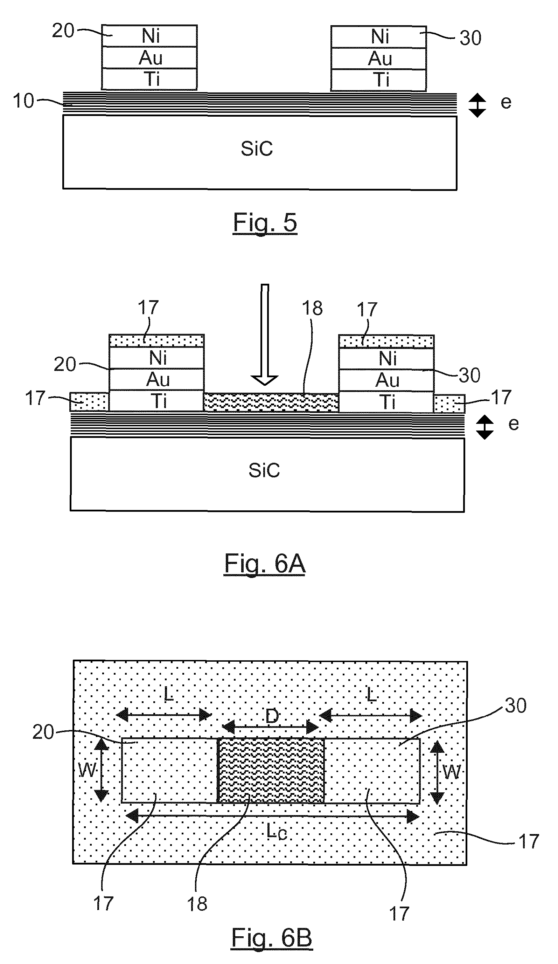

Step 200 consists in forming a source electrode 20 and a drain electrode 30 on the upper face of the multi-layer graphene stack 10. This step comprises three main phases: an electron-beam lithography phase, an etching phase and a metallic thin layer deposit phase. **Figure 3** is a top view of the in-process structure obtained after the lithography phase. **Figures 4** and **5** are a cross-sectional view of the in-process structure obtained respectively after the etching and deposit phases.

Regarding the lithography phase, a positive electro-sensitive resin (or resist film) 11 is deposited on the upper face of the multi-layer graphene stack 10. This electro-sensitive resin 11 is then irradiated, by means of an electron-beam, on the predefined rectangular areas 12 and 13 in order to make these predefined areas 12 and 13 sensitive to a chemical etching (by change of microstructure of the electro-sensitive resin). The lithography phase is carried out such that the predefined areas 12 and 13 are separated from each other of a predefined distance (D) (typically from some tens of nanometres to some tens of micrometers depending on the desired design), each predefined area 12 and 13 having a predefined width (W) (typically below 100 µm, such as 80 µm) and length (L) (typically below 100 µm, such as 80 µm) (figure 3).

It should be noted that the dimensional parameters will determinate the dimensional parameters of the main elements of the field effect transistor obtained by the method of the invention, namely: drain and source electrodes, conductive channel and gate dielectric.

Regarding the etching phase, the in-process structure is subjected to a selective etching process using a dry etching gas to selectively etch the predefined areas 12 and 13 (the non-irradiated resin being not sensitive to etching) to reveal openings 14 and 15. After etching, a mask 16 having a pattern comprising the openings 14 and 15 is obtained, the openings 14 and 15 being intended to the deposit of the source and drain electrodes at the desired location on the surface of the stack 10 **(****figure 4****).**

Regarding the deposit phase, thin layers of conductive electrically materials are successively deposited on the graphene stack 10 through the mask 16 to form the source and drain electrodes 20 and 30. In the present example, each electrode is constituted of a stack of three metallic thin layers: a first layer of Ti (Titanium), on which extends a second layer of Au (Gold), on which extends a third layer of Ni (Nickel) **(****figure 5****).**

At the end of step 200, the remaining non-irradiated resin forming the mask is removed from the graphene stack 10 by simple chemical treatment (typically using acetone and IPA solvent).

It should be noted that although the present example depicts a lithography process using a positive electro-sensitive resin, the skilled person will be able to carry out this step 200 by using a negative electro-sensitive resin and an adapted etching.

The following steps 300 and 400 aim at patterning the conductive channel of the field effect transistor using lithography and etching process.

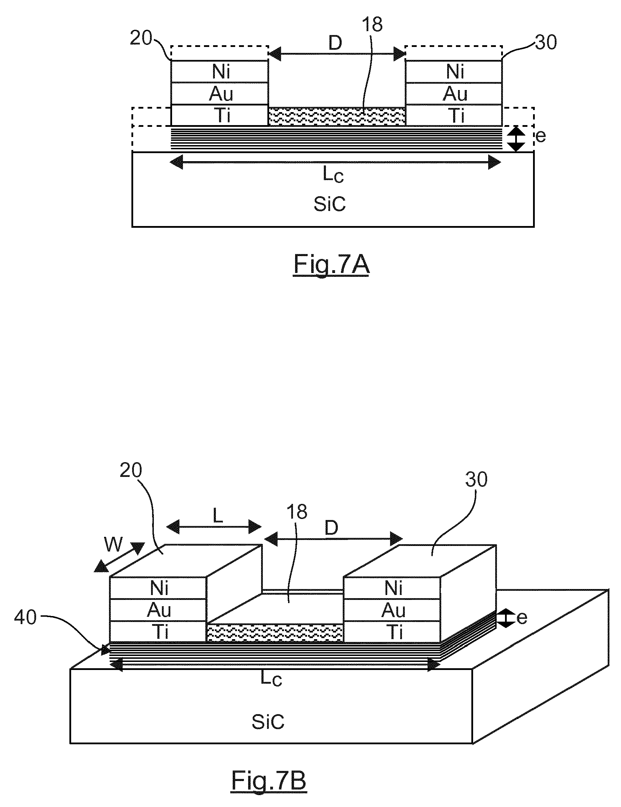

**Figures 6A** and **6B** are cross-sectional and top views, respectively, of the in-process structure obtained after the end of lithography step 300. **Figures 7A** and **7B** are cross-sectional and perspective views, respectively, of the in-process structure obtained respectively after the etching step 400.

In step 300, a negative electro-sensitive resin 17 is deposited on the structure obtained at previous step 200. A rectangular area 18 of the electro-sensitive resin 17, which extends between the source and drain electrodes 20 and 30 over the predefined distance D and over the predefined width W, is irradiated by means of an electron-beam in order to make this area of resin insensitive to a future attack by chemical etching (by change of microstructure of the electro-sensitive resin) as shown in **Figures 6A** and **6B****.** In other words, the resin which has been not irradiated during the lithography step is sensitive to a future attack by chemical etching. The irradiated electro-sensitive resin therefore acts as an etch-protective layer of a particular region located on the surface of the graphene stack 10, hereafter called "target region" (the principle of which is explained more in details below in relation with the steps 500 and 600), and which has the same dimensions.

The etch-protective layer 18, the source and drain electrodes 20 and 30 form an etch-protective mask used in the following step 400.

In step 400, the structure obtained at previous step 300 is subjected to a reactive-ion etching (RIE) treatment by using a dry etching gas (such as an oxygen plasma for example). The elements 18, 20 and 30 acting as an etch-protective mask, the dry etching gas is adapted to etch both the non-irradiated resin and the graphene non-protected by said etch-protective mask over the predefined thickness e, as shown in **Figures 7A** and **7B****.** Thus, only the graphene layers of said stack 10 located below the etch-protective mask remains intact. Instead of using a dry etching gas for that step of method, the skilled person can use other known techniques adapted to reveal microelectronic pattern, such as chemical developer.

After etching, a multi-layer graphene block 40 is obtained with the desired dimensions, namely a thickness equal to e (typically lower or equal than 6 nm, for example around 4 nm for ten graphene layers), a predefined width equal to W (typically a submicron width) and a length Lc (typically a submicron length) such that Lc = 2 x L + D (depending on the desired design). The multi-layer graphene block 40 thus obtained serves as basis for the future implementation of the conductive channel and gate dielectric performed in the next steps.

In step 500, the etch-protective layer 18 is removed from the surface of the graphene block 40 by chemical treatment (typically acetone and IPA solvent). This enables to reveal the target region of the graphene block 40 located between the source and drain electrodes.

The source and drain electrodes 20 and 30 form a fluorination-protective mask used in the following step 600.

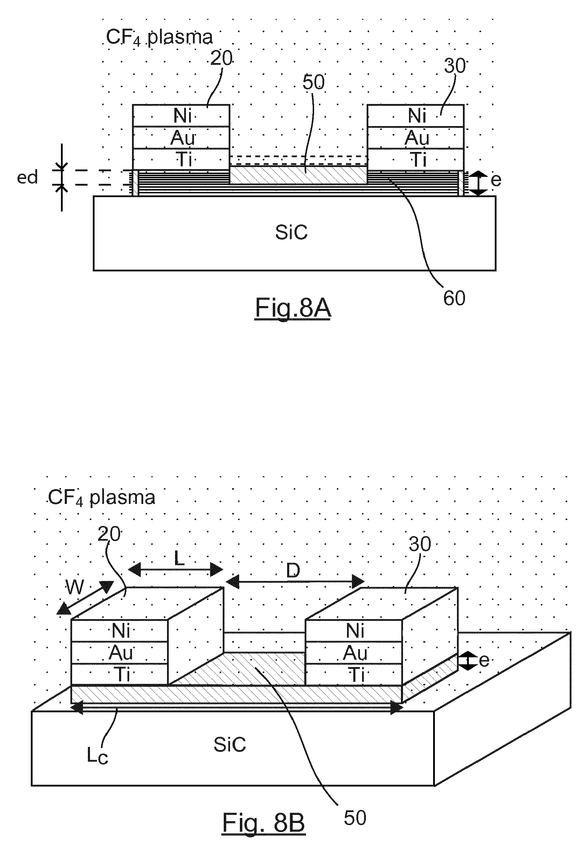

In step 600, the structure obtained at previous step 500 is subjected to a fluorination treatment during a predetermined period (for example 40 minutes allows to fluorinate approximately five upper layers of the graphene block 40) using a Fluorine-based plasmagenic gas 80 (such as CF₄, C₂F₆ CHF₃, CH₂F₂, CH₃F, SF₆, C₃F₈ or C₄F₈ for example), as illustrated on **figures 8A** and **8B****.** The structure is subjected to a treatment temperature of 300°C and a pressure around a few hundred Torr. More generally, the predetermined duration is comprised between 40 and 60 minutes (60 minutes allows to fluorinate approximately seven upper layers of the graphene block 40) and the predetermined temperature is comprised between 150 °C and 300 °C.

The fluorination enables to confer to the graphene new electrical proprieties as explained below. 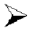

### Transversal diffusion of fluorine in the multi-layer graphene block

The source and drain electrodes acting as a fluorination-protective mask, the fluorine-based plasma 80 allows a transversal diffusion of fluorine into the graphene block 40 at the target region (which is not protected fluorination-protective by the mask), such that only the upper layers of graphene of said block are converted into fluorographene over a given thickness portion (e_{d}). This partial fluorination allows the layers of fluorographene converted to form the gate dielectric 50 (dielectric element) of the FET transistor. The given thickness portion is as a function of fluorination treatment parameters, and particularly the predetermined period. It corresponds to the thickness of said gate dielectric. Typically, the longer the period of treatment is, the higher the penetration depth of fluorine within the graphene block 40 is.

Thus, thanks to the step of target fluorination of the graphene block 40, a dielectric element, acting as gate dielectric, directly embedded in the graphene block is obtained. The fluorinated part (i.e. part of graphene block unmasked during the fluorination) corresponds to the gate dielectric (the fluorographene being dielectric) and the non-fluorinated parts of said graphene block (i.e. part of graphene block masked during the fluorination) corresponds to the conductive channel (the graphene being conductive) of the transistor.

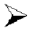 Lateral diffusion of fluorine in the multi-layer graphene block

At the same time, the fluorine-based plasma 80 allows a lateral diffusion of fluorine into the graphene block 40 at the lateral walls thereof (the lateral walls being also exposed to the plasma) over a given thickness portion, transforming that portion of graphene into fluorographene, and therefore into insulating material. The fluorographene obtained by lateral diffusion on the lateral walls ensures the insulation of the conductive channel from its surrounding, thereby reducing the risk of shortcut of the conductive channel after gate electrode deposition.

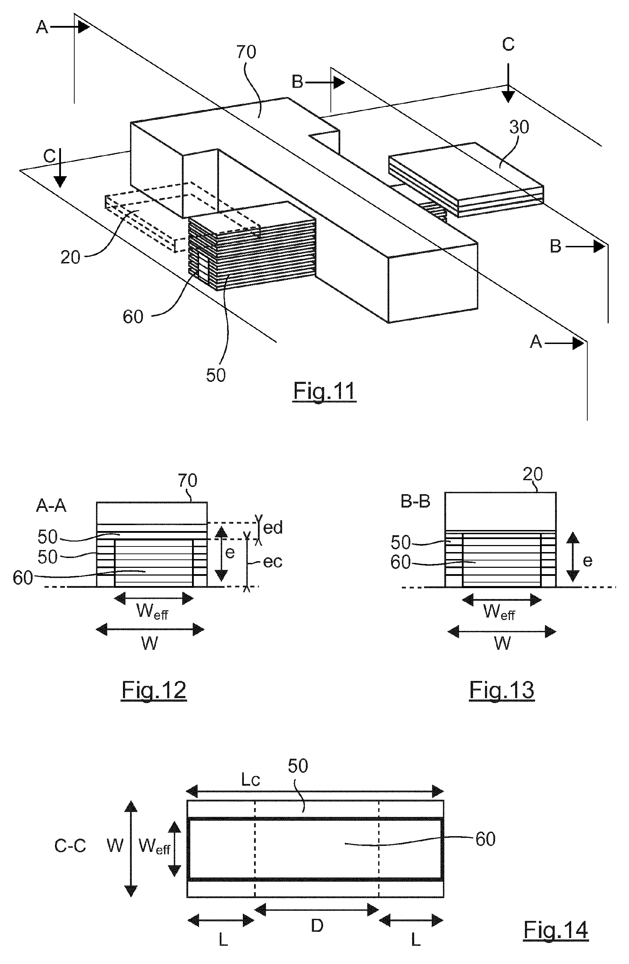

The effective width of the conductive channel 50 thus obtained is equal to W_{eff} and its length is equal to Lc as shown in **figures 12, 13** and **14****.** The width W corresponds to the width of the graphene block before fluorination. The thickness of the conductive channel 50 varies along its longitudinal axis: the thickness is equal to e (i.e. the total thickness of the graphene block which is typically around 4 nm for ten layers of graphene) for the channel part located below each of the source and drain electrode 20 and 30 **(****figure 13****)** and is equal to e_{c} such as e_{c} = e - e_{d} (typically e = 4 nm, e_{d} = 1.2 nm, e_{c} = 2.8 nm) for the channel part placed below the gate dielectric 50 **(****figure 12****).** For example, the thickness of the fluorinated graphene, e_{d}, can be comprised between 10 and 50% of the total thickness of the graphene block 40.

Routine test within the reach of the skilled person enable to select temperature, treatment period, and pressure conditions for obtaining the desired penetration depth and therefore the desired effective width of the conductive channel, in order to confer to the transistor operable electrical properties.

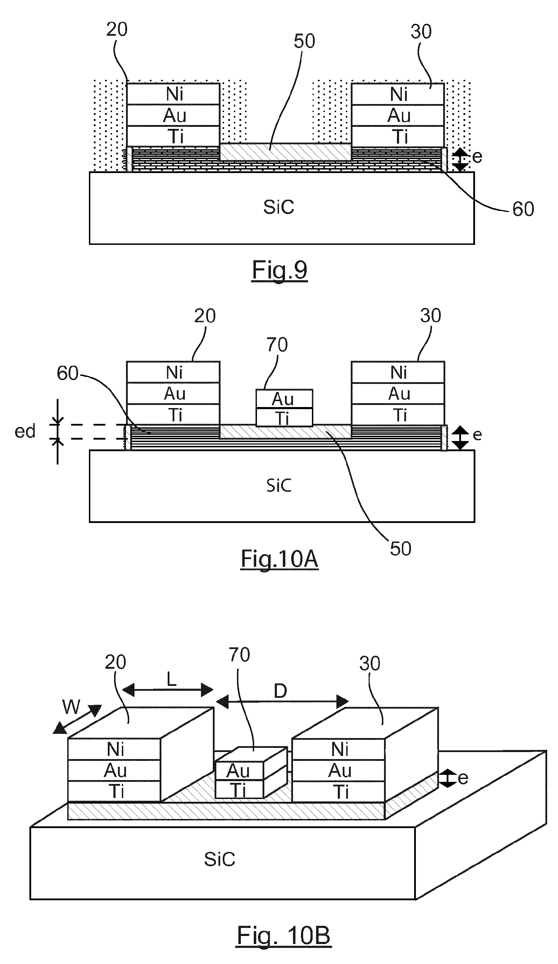

In step 700, a gate electrode 70 is formed on the gate dielectric 50 in a central position comprised between the source and drain electrodes 20 and 30. This step comprises three main phases: an electron-beam lithography phase, an etching phase and a thin layer deposition phase, as illustrated on **Figures 9, 10A** and **10B****.** The principle here is the same as that described above in relation with step 200 for the formation of source and drain electrodes.

An example of FET transistor obtained at the end of steps 100 to 700 is showed in **figure 11****.**

The gate dielectric 50, which is comprised between the conductive channel 60 and the gate electrode 70, ensures the control of flow of carriers travelled through the conductive channel 60, between the source and drain electrodes 20 and 30, via the gate electrode 70.

In generally manner, the dimensional parameters of the gate dielectric 50, the conductive channel 60 can be fixed, notably, as a function of the number of layers of graphene formed in step 100, the pattern of the mask used in step 200, and the penetration depth of fluorine obtained in step 600. These dimensional parameters can be chosen such that the FET transistor has optimized electrical behaviour (carrier mobility, leakage current, Dirac point, etc.).

The steps 200 and 300 described here above are based on an electro-beam lithography process. Thus is an example used only for purposes of illustration, and other lithography processes can be used without departing from the scope of the invention, such as photo-lithography for example.

The particular embodiment disclosed here above enables to obtain a graphene-based elementary field effect transistor (also called "nanoribbon graphene transistor"). Such elementary component is adapted to perform an elementary logic function of switch type. It comprises a dielectric element, which acts as gate dielectric, directly embedded in the graphene block, which acts as conductive channel. The gate dielectric, which is comprised between the conductive channel and the gate electrode, ensures the control of flow of carriers travelled through the channel via the gate electrode.

It should be noted that the steps 200 to 400 can be carried out as a function of the orientation of graphene terraces obtained after the growth step 100. Indeed during growth, the graphene layers forms on the SiC substrate as terraces arranged according to a predefined orientation. And steps 200 to 400 can be carried out either parallel or perpendicular to the predefined orientation of graphene layers in order to optimize electronic properties of the field effect transistor.

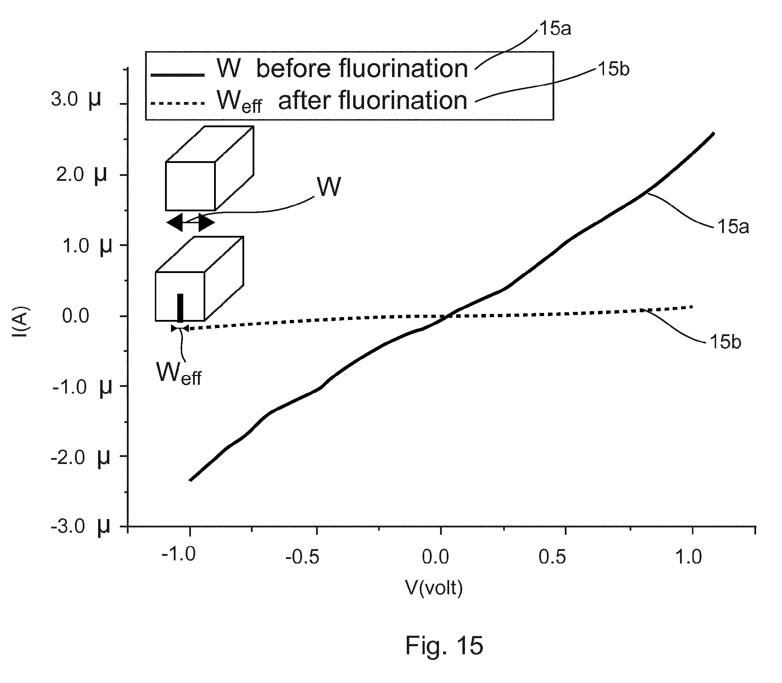

**Figure 15** graphically depicts the current-voltage characteristic obtained experimentally with a field effect transistor obtained by the method of the invention according to the first embodiment. Curves 15a and 15b has been obtained respectively before and after implementing fluorinating step 600. We notice that reducing the thickness of the effective channel (W_{eff}) involves reducing the current I travelling the structure, which means a better control of electrostatic properties of the FET transistor thus obtained.

Another embodiments of the invention can be envisaged without departing from the scope of the invention.

### • Second embodiment of the invention: Method for obtaining a graphene-based first-type non-volatile-memory field effect transistor.

This alternative embodiment of the invention comprises the following steps:
- first performing steps 100 to 600 of the method as described in figure 1;
- after performing the fluorinating step 600, forming an electron trap dielectric element 155 by partial ion implantation of the dielectric element 150;
- depositing a thin layer of dielectric material 180 on an upper face of the electron trap dielectric element 155, using for example an Atomic Layer Deposition of Aluminium oxide or Hafnium oxide for instance;
- depositing a gate electrode 170 on an upper face of said thin layer of dielectric material 180.

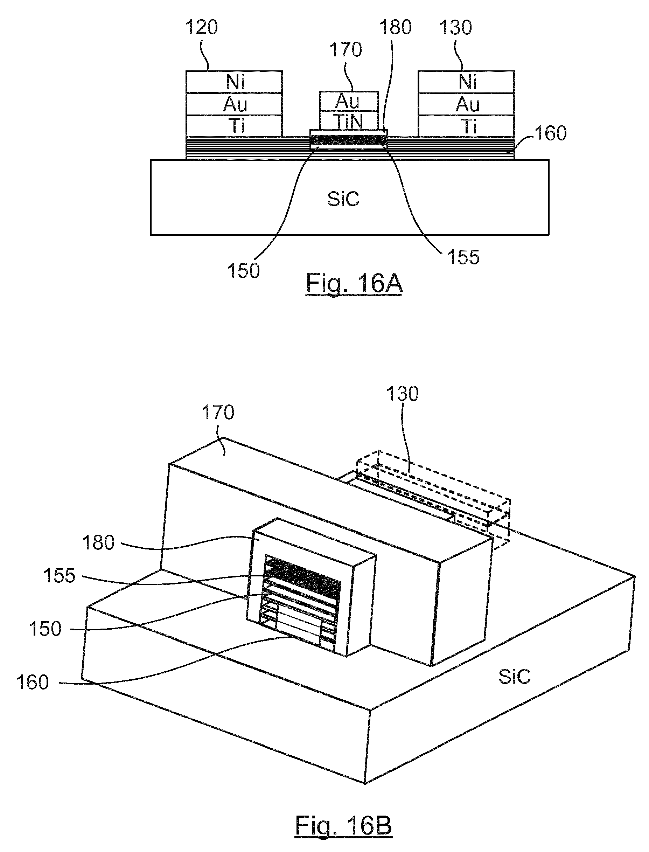

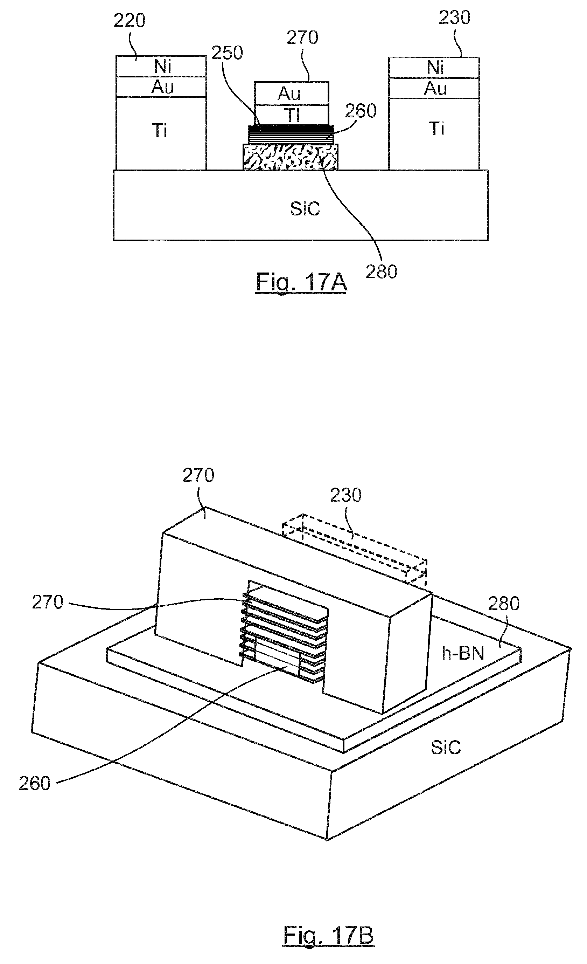

**Figures 16A-16B** shows the simplified structure of the graphene-based field effect transistor obtained by the method according to this second embodiment. In figure 17, the source electrode 220 is not showed for the sake of clarity of the figure.

The graphene-based field effect transistor thus obtained is a memory-type field effect transistor adapted to perform a non-volatile memory function. The ionized part of dielectric element (i.e. the upper part) 155 acts as electron trap (trapping medium) and the non-ionized part of dielectric element (i.e. the lower part) 150 acts as a tunnel barrier, both directly embedded in the graphene block. The parts of the graphene block which are not fluorinated acts as conductive channel. The thin layer of dielectric material 180 acts as blocking oxide of the transistor, this blocking oxide will help the electrostatic coupling between the gate electrode 170 and the conductive channel and permit the electron tunnelling through the tunnel barrier 150. In other words the blocking oxide ensures via the voltage applied to the gate electrode the control of flow of carriers travelling from the conductive channel to the electron trap through the bottom tunnel barrier. The elements 120, 130 and 170 are respectively source, drain and gate electrodes.

### • Third embodiment of the invention: Method for obtaining a graphene-based second-type non-volatile-memory field effect transistor.

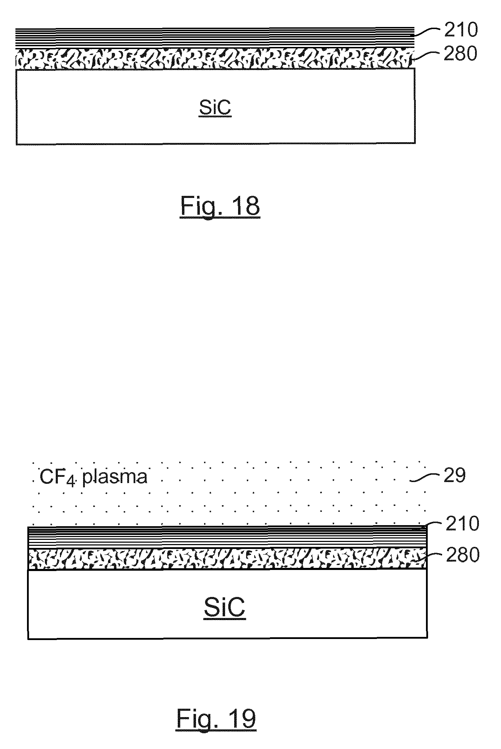

This particular embodiment is described in relation with **Figures 18 to 22** which illustrates, through section view, the principle of operation of the mains steps of the method. **Figures 17A and 17B** show the simplified structure of the graphene-based field effect transistor thus obtained. In figure 17B, the source electrode 220 is not showed for the sake of clarity of the figure.

In first step, a boron nitride (BN) thin layer 280 is deposited on a silicon carbide (SiC) substrate (conductive substrate), to form a base substrate. The SiC substrate here is doped in this particular embodiment to provide electrons within the structure and ensure the functions of non-volatile memory.

In second step (figure 18), a multi-layer graphene stack 210 is formed on the surface of boron nitride thin layer 280 using for example a molecular beam epitaxy (MBE) method (other known vacuum deposition methods can also be envisaged for that step). A number of graphene layers comprised between 8 and 10 layers has showed positive results in terms of electrical performances.

In third step (figure 19), the structure obtained at previous step is subjected to a fluorination treatment using a Fluorine-based plasmagenic gas 29 (such as CF₄ or C₂F₆ for example). The fluorination treatment is performed for a predetermined period (for example 40 minutes allows to fluorinate approximately five upper layers of the graphene block 40) under a predetermined temperature (for example around 300°C), a predetermined temperature (for example around a few hundred Torr). The fluorinating treatment is performed such that the upper part of the multi-layer graphene stack 210 is converted from graphene into fluorographene over a given thickness portion (in other words, it is a partial fluorination). The fluorination treatment parameters (duration, temperature, pressure) can be adapted as a function of the desired number of graphene layers to be transformed into fluorographene. It is at this stage that the thickness of the element dielectric of the transistor is defined as it depends on the number of fluorographene layers formed.

The principle of transversal and lateral diffusion of fluorine in the graphene block explained above in relation with the first embodiment also applies here in the same manner to the graphene stack 210.

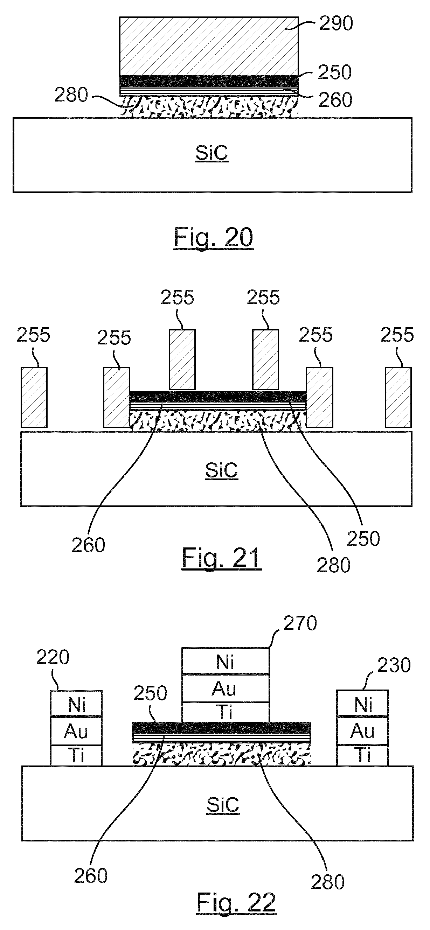

In fourth step (figure 20), a lithography process is carried out to form an etch-protective layer, of desired dimensions, over a target area of the upper face of the multi-layer graphene stack previously and partially fluorinated. To that end, an electro-sensitive resin is first deposited on the multi-layer graphene stack previously and partially fluorinated. An area of the electro-sensitive resin of desired dimensions is irradiated by means of an electron-beam in order to make this area of resin insensitive to a future attack by chemical etching. The irradiated electro-sensitive resin 290 will act as an etch-protective layer (or mask) of a particular region located on the surface of the graphene stack 10, hereafter called "target region". Then, a plasma etching is carried out to delete the fluorinated multi-layer graphene stack and the boron nitride thin layer 280, which are not protected by the etch-protective layer 290, thereby forming a conductive graphene block 260 embedding a dielectric element 250 (fluorographene). Then, the etch-protective layer 290 is removed from the graphene block to proceed to electrode deposition.

In fifth step (figure 21), a pattern 255 for electrode deposition is defined by e-beam lithography and etching process as illustrated in figure 21, such that:
- the source and drain electrodes 220 and 230 are deposited on the upper face of the silicon carbide (SiC) substrate on either side of and at equal distance of the graphene block;
- the gate electrodes is deposited on the upper face of the dielectric element 250 (fluorographene).

Once the pattern 255 defined, a metallic thin layer deposit phase is then performed by chemical vapour deposition: thin layers of conductive electrically materials are successively deposited through the pattern 255 to form the source, drain and gate electrodes 220, 230, 270: a first layer of Ti (Titanium), on which extends a second layer of Au (Gold), on which extends a third layer of Ni (Nickel).

It should be noted that for this particular embodiment the drain and source electrodes 220 and 230 must be electrically insulated from the graphene block.

The graphene-based field effect transistor thus obtained is a memory-type field effect transistor adapted to perform a non-volatile memory function. The dielectric element 250 acts as blocking oxide, directly embedded in the graphene block. The part of the graphene block which is not fluorinated acts as conductive channel (also commonly called "graphene floating gate"). The boron nitride thin layer 280 acts as tunnelling barrier. The dielectric element 250 ensures via the voltage applied to the gate electrode 270 the control of flow of carriers travelling through the floating gate (which stores electron) via the tunnel barrier.

## Claims

1. Method for obtaining a field effect transistor, **characterized in that** it comprises steps of:
a) forming (100) a multi-layer graphene stack (10) on a face of a base substrate, said multi-layer graphene stack having a predefined thickness;
b) depositing (200) a source and a drain electrode (20;30);
c) obtaining, by fluorinating, a graphene block partially fluorinated from said multi-layer graphene stack, the graphene block partially fluorinated comprising a fluorographene part forming a dielectric element within the graphene block;
d) depositing (700) a gate electrode.

2. Method according to claim 1, wherein the source and drain electrodes are deposited on an upper face of said multi-layer graphene stack, said step c) comprising steps of:
α) forming (300), by lithography, an etch-protective layer over an target area of a upper face of said multi-layer graphene stack, which extends between the source and drain electrodes,
β) etching (400), using the etch-protective layer and the source and drain electrodes as an etch-protective mask, said multi-layer graphene stack over the predefined thickness to form a conductive multi-layer graphene block (40);
γ) removing (500) said etch-protective layer from said graphene block to reveal said target area;
δ) fluorinating (600) said graphene block, using the source and drain electrodes as a fluorination-protective mask, during a predetermined period and at a predetermined temperature, such that an upper part of said graphene block corresponding to said revealed target area is converted into fluorographene over a given thickness portion, to form a dielectric element within said graphene block;
and wherein said step d) is performed on an upper face of said dielectric element.

3. Method according to any one of claims 2 and 3, wherein said step α) is carried out by electronic lithography comprising a step of depositing a electro-sensitive resin on the upper surface of said multi-layer graphene stack and a step of irradiating the electro-sensitive resin based on a pattern adapted to form said etch-protective layer over the target area.

4. Method according to any one of claims 2 and 3, wherein said step α) is carried out by photo-lithography comprising a step of depositing a photo-sensitive resin on the upper surface of said multi-layer graphene stack and a step of irradiating the photo-sensitive resin based on a pattern adapted to form said etch-protective layer over the target area.

5. Method according to any one of claims 1 to 4, wherein the source and drain electrode having each a predefined width (W) and being spaced from each other of a predefined distance (L), and said target area extends between the source and drain electrodes over the predefined width (W) and the predefined distance (D).

6. Method according to any one of claims 1 to 5, wherein said step β) is carried out using a reactive ion etching (RIE).

7. Method according to any one of claims 1 to 6, wherein said step δ) consists in subjecting said graphene block to a Fluor-based plasmagenic gas.

8. Method according to any one of claims 1 to 7, wherein, in said step δ), the predetermined duration is comprised between 40 and 60 minutes and the predetermined temperature is comprised between 150 and 300 °C.

9. Method according to any one of claims 1 to 8, wherein, said multi-layer graphene stack having graphene terraces oriented according to a predefined orientation, said steps b) and c) are carried out as a function of said predefined orientation.

10. Method according to claim 1, wherein the source and drain electrodes are deposited on an upper face of said multi-layer graphene stack, said step c) comprising steps of:
α) forming, by lithography, an etch-protective layer over an target area of a upper face of said multi-layer graphene stack, which extends between the source and drain electrodes,
β) etching, using the etch-protective layer and the source and drain electrodes as an etch-protective mask, said multi-layer graphene stack over the predefined thickness to form a conductive multi-layer graphene block having the dielectric element ;
γ) removing said etch-protective layer from said graphene block to reveal said target area;
δ) fluorinating said graphene block, using the source and drain electrodes as a fluorination-protective mask, during a predetermined period and at a predetermined temperature, such that an upper part of said graphene block corresponding to said revealed target area is converted into fluorographene over a given thickness portion, to form a dielectric element within said graphene block;
ε) forming an electron trap dielectric element by ion implantation of said dielectric element;
ζ) depositing a thin layer of dielectric material on an upper face of said electron trap dielectric element;
and wherein said step d) is performed on an upper face of said thin layer of dielectric material.

11. Method according to any one of claim 1 to 10, wherein:
- the base substrate is a silicon carbide (SiC) substrate having a C-terminated face and a Si-terminated face, and
- said step of forming a graphene layer stack is carried by thermal treatment of the silicon carbide substrate from the C-terminated face or Si-terminated face.

12. Method according to claim 1, comprising, before performing said step a), a step of depositing a boron nitride (BN) thin layer on a silicon carbide (SiC) substrate to form said base substrate, said step c) comprising steps of:
α) fluorinating said multi-layer graphene stack, during a predetermined period and at a predetermined temperature, such that an upper part of said multi-layer graphene stack is converted into fluorographene over a given thickness portion;
β) forming, by lithography, an etch-protective layer over an target area of a upper face of said fluorinated multi-layer graphene stack;
γ) etching, using the etch-protective layer, said fluorinated multi-layer graphene stack over the predefined thickness to form the graphene block comprising the dielectric element;
δ) removing said etch-protective layer from said graphene block to reveal said dielectric element;
said step b) is performed after said step δ) such that the source and drain electrodes are deposited on an upper face of said silicon carbide (SiC) substrate, on either side of and at equal distance of the graphene block,
said step d) is performed on an upper face of said dielectric element.

13. Method according to any one of claims 1 to 12, wherein said graphene layer stack comprises a number of layers comprised between 2 and 16.
